# DEMANDE DE BREVET EUROPEEN

(11) **EP 4 836 625 A1**
(43) Date de publication de la demande: **04.11.2026**
(21) Numéro de dépôt: 26174602.8
(22) Date de dépôt: 24.04.2026
(51) Int. Cl.: H10B 43/27, H10B 41/20, H10B 41/27, H10B 41/35, H10B 43/20, H10B 51/20, H10D 30/01, H10D 30/69, G11C 11/22, G11C 16/04, G11C 16/10, G11C 16/26, H10B 43/35

(54) **MÉMOIRE FLASH NAND TRIDIMENSIONNELLE À BASE DE GAZ BIDIMENSIONNEL D ÉLECTRONS ET PROCÉDÉ DE FABRICATION D'UNE TELLE MÉMOIRE**

(30) Priorité: 28.04.2025 FR 2504487
(71) Demandeur: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR); Institut Polytechnique de Grenoble, 38000 Grenoble (FR)
(72) Inventeur: KANDAZOGLOU, Aurélie, 38054 GRENOBLE CEDEX 09 (FR); ATTANE, Jean-Philippe, 38054 GRENOBLE CEDEX 09 (FR); VILA, Laurent, 38054 GRENOBLE CEDEX 09 (FR); SAVERO TORRES, Williams, 38054 GRENOBLE CEDEX 09 (FR); SGARRO, Paolo, 38054 GRENOBLE CEDEX 09 (FR); PAPPAS, Panagiotis, 38054 GRENOBLE CEDEX 09 (FR); BIBES, Manuel, 38054 GRENOBLE CEDEX 09 (FR)
(74) Mandataire: Cabinet Camus Lebkiri

(57) **Abrégé**

L'invention a pour objet une mémoire de type Flash NAND comprenant une pluralité de lignes mémoire (20, 30, 40, 50), lesdites lignes mémoire (20, 30, 40, 50) étant disposées pour former une architecture tridimensionnelle de mémoire Flash NAND, chaque ligne mémoire (20) comprenant :
- un ensemble (21, 22, 23) de cellules mémoire connectées en série ;
- un multicouche (25) comprenant une première couche (26) et une deuxième couche (27), la première couche (26) comprenant un oxyde, la deuxième couche (27) comprenant un métal réducteur, la deuxième couche (27) étant au contact de la première couche (26) de sorte à former une interface entre la première (26) et la deuxième couche (27), le multicouche (25) comprenant en outre un gaz bidimensionnel d'électrons à l'interface entre la première (26) et la deuxième couche (27), ledit gaz bidimensionnel d'électrons formant un canal conducteur électrique (25.1) connectant en série les cellules mémoire comprises dans ledit ensemble.

## Description

### DOMAINE TECHNOLOGIQUE DE L'INVENTION

L'invention appartient au domaine des mémoires de type NAND Flash.

Un aspect de l'invention porte sur une mémoire de type NAND Flash tridimensionnelle à base de gaz bidimensionnel d'électrons. Un autre aspect de l'invention porte sur un procédé de fabrication d'une mémoire de type NAND Flash à base de gaz bidimensionnel d'électrons.

### ARRIERE-PLAN TECHNOLOGIQUE DE L'INVENTION

Afin de répondre aux défis posés par la loi de Moore, l'augmentation de la densité de cellules des dispositifs mémoire est déterminante pour assurer une capacité de stockage répondant aux besoins de stockage des données, qui augmentent de façon exponentielle.

Les mémoires Flash sont des dispositifs mémoire utilisant des transistors de type non-volatil, ou transistor flash, en tant que cellules mémoires.

Parmi les mémoires Flash, la dualité densité/rapidité d'écriture réside dans le choix entre deux architectures différentes : l'architecture NAND Flash ou l'architecture NOR Flash. Une mémoire de type NAND comprend des cellules mémoire connectées en série tandis qu'une mémoire de type NOR comprend des cellules mémoire connectées en parallèle.

L'architecture NAND flash permet d'obtenir une grande densité de cellules (jusqu'au Térabyte) car les transistors sont connectés en série via leur canal de conduction, tandis que l'architecture NOR flash permet d'accéder aléatoirement à n'importe quel transistor et repose sur l'injection d'électrons accélérés par une haute tension drain-source pour une écriture rapide. Ainsi, c'est l'architecture NAND flash qui est généralement choisie afin d'assurer la plus grande capacité de stockage possible.

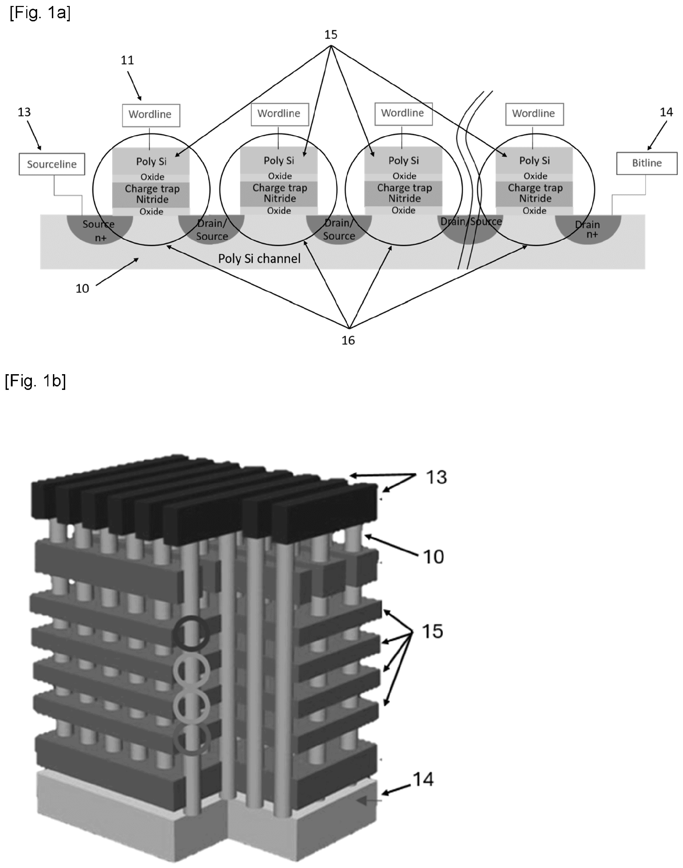

Le passage de la mémoire NAND Flash planaire à la mémoire NAND Flash tridimensionnelle ou 3D NAND Flash représente une grande avancée pour l'augmentation de la densité de cellules. La [Fig. 1a] illustre l'architecture NAND d'une mémoire Flash planaire, montrant la connexion des différentes cellules mémoire 16 en série via leur canal de conduction 10. Chaque cellule mémoire 16 possède une électrode de grille 15, reliée à une ligne de mot 11. La mémoire NAND planaire illustrée à la figure 1a est connectée au reste du dispositif au moyen d'une électrode de source 13 et une électrode de drain 14.

Concernant l'assemblage en trois dimensions ou 3D, il est possible de le réaliser en mettant à la verticale, soit la grille 15, soit le canal de conduction 10 de la mémoire NAND Flash. Dans le cas du canal vertical, cela revient à prendre une mémoire NAND flash planaire, la mettre à la verticale de sorte à ce que le canal de conduction soit vertical, et de l'enrouler sur elle-même avec le canal en son centre et les grilles à l'extérieur.

La structure de type BICS (Bit Cost Scalable selon la terminologie anglaise), présentée en [Fig. 1b] est un exemple de mémoire Flash NAND tridimensionnelle à structure verticale ou NAND verticale. La mémoire illustrée à la figure 1b possède un canal à la verticale, ce qui permet le passage du courant dans la structure à la verticale, limitant les fuites et les interférences entre les cellules. De plus, chaque NAND Flash planaire est assemblée en 3D de la façon suivante : le drain de chaque NAND Flash planaire est connecté à une ligne de bit ou bitline, chaque source est connectée à une ligne de source ou sourceline et chaque grille à une ligne de mot ou wordline.

La mémoire 3D NAND présente un empilement de cellules mémoire dans les trois dimensions, ce qui permet d'augmenter la densité de cellules sur une même surface. Cependant, la fabrication de ces dispositifs demeure un grand défi en raison de la complexité de leur structure.

Le développement des mémoires NAND Flash à piégeage de charges permet de simplifier la fabrication, mais l'empilement des couches reste complexe. A l'heure actuelle, les mémoires 3D NAND Flash sont essentiellement fabriquées à partir de cellules avec un canal de conduction en poly-silicium. L'un des empilements le plus simple est fait de 5 couches Silicium/Oxyde/Nitrure/Oxyde/Silicium. Le canal de conduction est alors en poly-silicium, la barrière tunnel est en oxyde et la couche de piégeage de charges en nitrure de silicium Si₃N₄.

Toutefois, des études ont montré que la présence de grains dans le canal en poly silicium avec différentes orientations cristallographiques engendre de la rugosité de surface, ce qui limite les performances, en particulier l'endurance de la mémoire. De plus, cet effet est décuplé à mesure que l'épaisseur du canal est réduite pour optimiser l'intégration du dispositif mémoire. Par ailleurs, dans le cas d'une procédure de fabrication de type « gate-last », la couche de piégeage de charge en nitrure de silicium Si₃N₄ est déposée sur le canal dont la rugosité de surface détériore également les propriétés de la couche de piégeage.

Par ailleurs, la fabrication de la plupart des transistors non-volatils requiert le dépôt d'au moins 5 couches minces, nécessaires pour réaliser à la fois le canal conducteur électrique et le sous-ensemble à états rémanents contrôlable électriquement. Cela rend la fabrication des mémoires 3D NAND Flash extrêmement complexe.

Aujourd'hui, d'autres types de transistors non-volatils ont été proposés. Par exemple, dans la demande de brevet FR3132386A1, la demanderesse divulgue un nouveau type de transistor à effet de champ comprenant seulement deux couches minces. Toutefois, il n'existe pas aujourd'hui de mémoires 3D NAND Flash utilisant des transistors non-volatils qui soient à la fois simples à fabriquer et performantes.

En d'autres termes, il n'existe pas aujourd'hui de solution pour obtenir des mémoires 3D NAND Flash avec une très haute densité de cellules mémoire et qui soient à la fois simples à fabriquer, fiables et avec une endurance élevée.

### RESUME DE L'INVENTION

Pour résoudre au moins partiellement les problèmes techniques évoqués précédemment, l'invention porte sur une mémoire de type NAND Flash comprenant une pluralité de lignes mémoire, lesdites lignes mémoire étant disposées pour former une architecture tridimensionnelle de mémoire NAND Flash, chaque ligne mémoire comprenant un ensemble de cellules mémoire connectées en série, chaque ligne mémoire comprenant :
- un ensemble de cellules mémoire connectées en série ;
- une multicouche comprenant une première couche et une deuxième couche, la première couche comprenant un oxyde, la deuxième couche comprenant un métal réducteur, la deuxième couche étant au contact de la première couche de sorte à former une interface entre la première et la deuxième couche, la multicouche comprenant en outre un gaz bidimensionnel d'électrons à l'interface entre la première et la deuxième couche, ledit gaz bidimensionnel d'électrons formant un canal conducteur électrique connectant en série les cellules mémoire comprises dans ledit ensemble ;
- un élément de remplissage dudit ensemble de cellules mémoires connectées en série, ledit élément de remplissage étant en matériau isolant, ledit multicouche étant au contact de l'élément de remplissage ;
- Chaque cellule mémoire comprenant :
   ∘ un sous-ensemble à états rémanents présentant deux états rémanents contrôlables électriquement, ledit sous-ensemble à états rémanents étant en contact avec le canal conducteur électrique, chaque état rémanent contrôlable électriquement étant associé à une valeur différente de conductivité du canal conducteur électrique ;
   ∘ une électrode de grille en contact avec la multicouche pour contrôler électriquement les deux états rémanents.

On entend par ligne mémoire ou « string » selon la terminologie anglaise un élément d'une mémoire 3D NAND Flash comprenant un ensemble de cellules mémoire connectées en série. Dans une architecture tridimensionnelle de mémoire de type NAND Flash, les extrémités de chaque ligne mémoire sont connectées à deux électrodes, respectivement une ligne de bit et une ligne de source (respectivement bitline et sourceline selon la terminologie anglaise).

On entend par cellule mémoire un composant électronique possédant un sous-ensemble à états rémanents. Une cellule mémoire est par exemple un transistor à effet de champ possédant deux états résistifs non-volatils.

On entend par architecture tridimensionnelle de mémoire NAND Flash une disposition des lignes mémoire pour former une mémoire de type NAND de façon connue d'une personne du métier. Une architecture tridimensionnelle de mémoire NAND Flash comprend des lignes mémoire disposées parallèlement les unes aux autres. Il existe principalement deux différentes orientations pour les lignes mémoires : soit le canal est à la verticale et la grille est horizontale, donc les lignes mémoires sont verticales, ce qui est communément choisi, soit la grille est à la verticale et le canal est horizontal, donc les lignes mémoires sont horizontales.

On entend par élément de remplissage un élément en matériau isolant s'étendant selon la ligne mémoire, en son centre. Par exemple, l'élément de remplissage est l'élément déposé au centre d'un nanofil dont les parois sont composées de la multicouche déjà déposée.

On entend par connexion en série des cellules mémoire, une connexion réalisée en connectant électriquement la zone dite de drain d'une cellule mémoire et la zone dite de source de la cellule mémoire suivante.

Le contrôle électrique du sous-ensemble à états rémanents est réalisé en appliquant une tension électrique entre l'électrode de grille et la ligne de bit et/ou la ligne de source. En d'autres termes, le sous-ensemble à états rémanents, formé dans la première couche et à proximité de l'interface entre la première et la deuxième couche, est modulé en fonction de la tension appliquée sur l'électrode de grille.

Avantageusement, l'utilisation d'une multicouche pour réaliser à la fois le canal conducteur électrique et le sous-ensemble à états rémanents permet de simplifier la structure de la mémoire 3D NAND Flash en réduisant le nombre de couches minces à déposer lors de sa fabrication. En effet, la mémoire NAND Flash tridimensionnelle selon l'invention requiert seulement deux couches pour former à la fois le canal conducteur et le sous-ensemble à états rémanents, ce qui simplifie beaucoup la structure par rapport à l'état de la technique.

Par ailleurs, le fait de pouvoir créer à la fois un gaz bidimensionnel d'électrons et un sous-ensemble à états rémanents à l'interface oxyde/métal permet de réduire les problèmes de rugosité de surface rencontrés dans les mémoires 3D NAND Flash selon l'état de l'art, notamment en évitant d'utiliser du silicium polycristallin.

La mémoire 3D NAND Flash selon l'invention comprend donc des cellules mémoire formées par des transistors non-volatils à base de gaz bidimensionnel d'électrons à l'interface oxyde/métal.

Des mesures montrent les performances très intéressantes du gaz d'électrons en tant que canal de conduction. En effet, un transistor non-volatil à base de gaz bidimensionnel d'électrons présente une grande densité de porteurs (10¹⁴ cm⁻²) et un ratio des résistances On/Off de 10⁵. De plus, son endurance est supérieure à 10⁶ cycles et sa rétention est extrapolée jusqu'à 10 ans. Par ailleurs, sa non-volatilité est dû à un sous-ensemble rémanent par piégeage de charges, ferroélectricité, par effet de migration d'ions, ou par une combinaison de ces effets.

Dans la mémoire 3D NAND Flash selon l'invention, le transistor non-volatil à base d'un gaz bidimensionnel d'électrons à l'interface oxyde/métal est utilisé comme un élément de mémoire et intégré dans une architecture tridimensionnelle de mémoire NAND Flash.

L'idée de faire une 3D NAND Flash à base d'un gaz bidimensionnel d'électrons à l'interface oxyde/métal est contrintuitive pour la personne du métier car dans les transistors, les oxydes pérovskites sont généralement utilisés en tant que matériaux ferroélectriques pour des cellules mémoires ferroélectriques, avec PZT par exemple, et non pour la formation du canal de conduction. En revanche, des avancées récentes concernant les dépôts par couche atomique avec du SrTiO₃ et du BaTiO₃ par exemple, ont démontré la possibilité de réaliser une structure oxyde pérovskite/métal par dépôt par couche atomique et d'observer un gaz d'électrons à l'interface oxyde/métal. Cela implique qu'il est possible d'assembler des transistors non-volatils à base d'un gaz bidimensionnel d'électrons à l'interface oxyde pérovskite/métal.

L'obtention d'une mémoire 3D NAND Flash selon l'invention requiert donc d'une combinaison qui n'avait jamais été envisagée auparavant car elle nécessite une grande expertise dans différents domaines, à savoir la 3D NAND Flash, la création d'un gaz d'électrons à l'interface oxyde/métal et l'optimisation de ses propriétés de transport, mais aussi les techniques de dépôts telles que le dépôt par couche atomique. La mémoire 3D NAND Flash selon l'invention est donc une alternative inédite aux mémoires 3D NAND Flash proposées jusqu'à présent, avec un potentiel technologique élargi du fait des diverses propriétés du gaz bidimensionnel d'électrons. Par exemple, la non-volatilité peut également permettre d'envisager un transistor avec des fonctionnalités supplémentaires, comme une fonction mémoire ou logique.

Selon des modes de réalisation particuliers, la mémoire 3D NAND Flash selon l'invention présente une ou plusieurs des caractéristiques suivantes, prise(s) isolément ou selon toutes les combinaisons techniquement possibles :
- l'ensemble de cellules mémoire forme un nanofil; le nanofil est par exemple à section cylindrique ;
- la première couche comprend le sous-ensemble à états rémanents ; avantageusement, cet arrangement permet d'obtenir un sous-ensemble à états rémanents par piégeage de charges ;
- la première couche comprend l'élément de remplissage ;
- chaque ligne mémoire s'étend entre un premier contact électrique dit drain de ligne mémoire et un deuxième contact électrique dit source de ligne mémoire, ladite mémoire comprenant en outre un circuit de pilotage de mémoire, ledit circuit de pilotage comprenant :
   ∘ au moins une ligne de bit connectant plusieurs drains de ligne mémoire ;
   ∘ au moins un sélecteur de ligne mémoire composé de transistors volatils ;
   ∘ au moins une ligne de sélecteur de source connectant plusieurs sources de ligne mémoire ;
   ∘ au moins une ligne de source connectant plusieurs sources de ligne mémoire ;
   ∘ au moins une ligne de mot connectant les électrodes de grille de cellules mémoires appartenant à des lignes mémoire différentes ;
- les lignes mémoire sont parallèles les unes aux autres ;
- les lignes mémoire sont parallèles les unes aux autres avec deux configurations possibles : dans une première configuration, le canal est à la verticale et la grille à l'horizontale et dans une deuxième configuration, le canal est à l'horizontale et la grille à la verticale ;
- la première couche comprend un oxyde pérovskite choisi dans un groupe comprenant des composés chimiques de type ABO₃,A et B étant des cations, ledit groupe comprenant : SrTiO3, KaTiO3, BaTiO3, PbZr1-xTixO3 avec x variant entre 0 et 1, [1-x]Pb(Mg1/3Nb2/3)O3 - xPbTiO3 avec x variant entre 0 et 1, BiFeO3, Pr0,7Ca0,3MnO3 et YMnO3 ;
- les oxydes pérovskites de type SrTiO3, KaTiO3, BaTiO3, Pr0,7Ca0,3MnO3 ou YMnO3 sont dopés ; on entend par oxydes pérovskites dopés, des oxydes pérovskites dans lesquels certains cations sont remplacés par d'autres en faible proportion ;
- l'oxyde pérovskite de type BiFeO3 est dopé par des éléments de la famille des terres rares sur le site du Bi ou en Mn sur le site de Fe ;
- la première couche comprend un oxyde choisi dans le groupe comprenant : oxyde de vanadium (VO₂), oxyde de gadolinium (Gd₂O₃) et dioxyde de chrome (CrO₂) ;
- la première couche comprend une bicouche comprenant une couche en GaOₓ et une couche en AIN, un gaz bidimensionnel d'électrons se formant à l'interface entre la couche en Ga0x et la couche en AIN ;
- la première couche comprend un oxyde choisi dans un groupe comprenant : ZnO, In₂0₃, SnO₂, Ga₂03, Ti0₂ et leurs alliages ; des exemples d'alliages sont ITO formé par In₂0₃ ou IGZO formé par In₂0₃, Ga₂0₃ et Zn0 ;
- la première couche comprend un oxyde d'Hafnium de type Hf₁₋ₓMₓO₂, avec M étant par exemple Zr, Ga, Y et x variant entre 0 et 1, ou un alliage de (Hf₁₋ₓZrₓ)O₂ et (Hf₁₋ₓGaₓ)O₂;
- la première couche comprend un oxyde d'Hafnium de type Hf₁₋ₓMₓO₂, avec M étant par exemple Zr, Ga, Y, et x variant entre 0 et 1 ou leurs alliages ; dans ce cas, la première couche n'a pas la structure pérovskite ;
- La première couche comprend du poly-fluorure de vinylidène ;
- La première couche comprend un matériau de type halogénure pérovskite tel que : CsPbBr₃, MAPbI₃, ou MAPbBr₃
- la deuxième couche comprend un métal réducteur, ledit métal réducteur étant de préférence choisi dans le groupe comprenant : tantale, yttrium, magnésium, aluminium et ruthénium ;
- la deuxième couche présente une concentration atomique en métal supérieure ou égale à 50% ;
- le sous-ensemble à états rémanents comprend une couche contrôlable électriquement par effet de charge piégée ou par effet ferroélectrique ou par effet de migration d'ions ou par combinaison de plusieurs de ces effets ;
- chaque cellule mémoire comprend :
   ∘une première zone dite zone de source ;
   ∘ une deuxième zone dite zone de drain ;
   ∘ la zone de source et la zone de drain étant électriquement connectées par une portion du canal conducteur électrique s'étendant entre la zone de source et la zone de drain ;
- la première couche est déposée au contact de l'élément de remplissage, par exemple sur l'extérieur d'un nanofil formant le canal, la deuxième couche est déposée au contact de la première couche ; par exemple l'élément de remplissage est déposé au centre du nanofil ;
- l'élément de remplissage est déposé sur l'extérieur du nanofil formant le canal, la deuxième couche est déposée au contact de l'élément de remplissage sur la paroi intérieur du nanofil et la première couche est déposée au centre du nanofil, au contact de la deuxième couche ;
- le matériau isolant formant l'élément de remplissage comprend l'oxyde compris dans la première couche ; cela permet de simplifier ultérieurement la fabrication de la mémoire 3D NAND Flash, en utilisant le même oxyde en tant qu'élément de support et en tant que première couche de la multicouche ;
- la multicouche comprend en outre une couche en MgO, HfO₂, Al₂O₃, SiO₂ ou Si₃N₄ déposée au contact de la deuxième couche ; la couche en MgO, Al₂O₃, SiO₂ ou Si₃N₄ permet de protéger la deuxième couche par exemple lors du dépôt des électrodes de grille ;
- l'élément de remplissage de l'ensemble de cellules mémoire est un nanofil. Dans un premier cas, la multicouche est radialement extérieure au nanofil et l'électrode de grille étant radialement extérieure à la multicouche. Dans un second cas, la multicouche est radialement intérieure au nanofil et l'électrode de grille est radialement extérieure à l'élément de remplissage ; le nanofil peut par exemple être à section cylindrique.
- la première couche comprend un oxyde d'Hafnium de type Hf₁₋ₓMₓ0₂, avec M étant par exemple Zr, Ga, Y et x variant entre 0 et 1, ou un alliage de (Hf₁₋ₓZrₓ)0₂ et (Hf₁₋ₓGaₓ)0₂.
- la première couche (26) comprend un oxyde choisi dans le groupe suivant : SiOₓNₓ, (Ta₂O₅)ₓ (TiO₂)₁₋ₓ ou (Nb₂O₅₎ₓ(TiNb₂O₇)₁₋ₓ avec x variant entre 0 et 1.
- l'oxyde est choisi dans le groupe comprenant : oxyde de vanadium (VO2), oxyde de gadolinium (Gd2O3), oxyde de zinc (ZnO) ou oxyde de chrome (CrO2), ou un mélange ou combinaison d'éléments de ce groupe.
- l'oxyde est un oxyde conducteur choisi dans le groupe comprenant : oxyde d'étain et d'indium (ITO), oxyde d'étain dopé au fluor (FTO), anatase TiO2 dopé au niobium (NTO), oxyde de zinc ou une combinaison ou mélange d'éléments de ce groupe.
- la première couche est déposée au contact de la grille, la deuxième couche est déposée au contact de la première couche et l'élément de remplissage est déposé au cœur du canal conducteur électrique, au contact de la deuxième couche.
- l'élément de remplissage est déposé au contact de la grille, la deuxième couche est déposée au contact de l'élément de remplissage et la première couche est déposée au contact de la deuxième couche.
- le matériau isolant formant l'élément de remplissage est fait du même oxyde que celui compris dans la première couche.

L'invention a également pour objet un procédé de fabrication d'une mémoire 3D NAND Flash selon l'invention comprenant une étape de dépôt de la première couche et une étape de dépôt de la deuxième couche, le dépôt étant un dépôt par couches atomiques.

La méthode de dépôt par couche atomique (ou « Atomic Layer Deposition », ALD, selon la terminologie anglaise) est une méthode de dépôt chimique. Elle consiste à exposer la surface du substrat à différents précurseurs, de façon successive, afin d'obtenir les couches les plus minces possible.

Avantageusement, le dépôt par couches atomiques permet de contrôler très précisément l'épaisseur de la première et de la deuxième couche, pour des structures complexes. Il est donc possible d'obtenir un gaz bidimensionnel d'électrons aux propriétés contrôlées.

### BREVE DESCRIPTION DES FIGURES

D'autres avantages et caractéristiques de l'invention apparaîtront à la lecture de la description qui suit, illustrée par les figures dans lesquelles :
- [Fig. 1a] illustre une vue en coupe d'une ligne mémoire NAND Flash planaire ;
- [Fig. 1b] illustre une représentation schématique d'une mémoire 3D NAND Flash à canal vertical selon l'état de la technique ;
- [Fig. 2] illustre un mode de réalisation d'une ligne mémoire d'une mémoire 3D NAND Flash selon l'invention ;
- [Fig. 3] illustre un mode de réalisation d'une mémoire 3D NAND Flash selon l'invention ;
- [Fig. 4] illustre un graphe représentant la résistivité du gaz bidimensionnel d'électrons formant le canal en fonction de la tension de grille ;
- [Fig. 5] illustre schématiquement la formation d'un sous-ensemble à états rémanents par piégeage de charge dans une cellule mémoire d'une mémoire 3D NAND Flash selon l'invention ;
- [Fig. 6] illustre un graphe caractérisant l'endurance d'une cellule mémoire d'une mémoire 3D NAND Flash selon l'invention ;
- [Fig. 7] illustre schématiquement une procédure de programmation d'une mémoire 3D NAND Flash selon l'invention ;
- [Fig. 8] illustre schématiquement une procédure de lecture d'une mémoire 3D NAND Flash selon l'invention ;
- [Fig. 9] illustre schématiquement une procédure de réinitialisation d'une mémoire 3D NAND Flash selon l'invention.

### DESCRIPTION DETAILLEE

Les figures [Fig. 1a] et [Fig. 1b] ont été décrites en relation avec l'état de la technique.

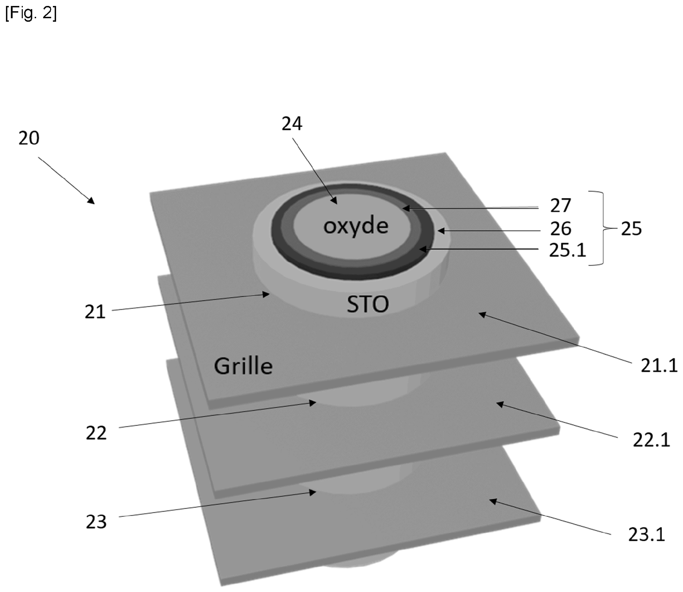

La [Fig. 2] illustre un mode de réalisation d'une ligne mémoire 20 d'une mémoire 3D NAND Flash selon l'invention.

Telle qu'illustrée à la Fig. 2, la ligne mémoire 20 comprend un ensemble de cellules mémoire 21, 22, 23 connectées en série. De façon connue, la connexion série se fait en connectant le drain d'une cellule mémoire à la source de la cellule mémoire suivante.

La Fig. 2 présente une vue en coupe de la première cellule mémoire 21 de la ligne mémoire 20. La cellule mémoire 21 comprend un multicouche 25. Le multicouche 25 comprend une première couche 26 et une deuxième couche 27. La première couche 26 comprend un oxyde tandis que la deuxième couche 27 comprend un métal réducteur. A l'interface, le gaz bidimensionnel d'électrons 25.1 qui est formé représente le canal de conduction.

La deuxième couche 27 est au contact de la première couche 26. L'interface entre la première 26 et la deuxième couche 27 comprend un gaz bidimensionnel d'électrons formant un canal conducteur électrique 25.1.

Selon un mode de réalisation, après le dépôt de la multicouche, l'élément de remplissage 24 est déposé au centre du nanofil. Tel qu'illustré à la Fig. 2, l'élément de remplissage 24 est déposé au contact de la multicouche 25 de chaque cellule mémoire qui est ici de forme cylindrique. La multicouche 25 est radialement extérieure à l'élément de remplissage 24.

Selon un mode de réalisation, l'élément de remplissage 24 peut être radialement extérieur à la multicouche 25, alors constituée au centre de la première couche 26 et sur l'extérieur de la deuxième couche 27, au contact de l'élément de remplissage 24.

Selon un mode de réalisation, le multicouche 25 peut comprendre en outre une couche en MgO, HfO₂, Al₂O₃, SiO₂ ou Si₃N₄ déposée au contact de la deuxième couche 27. Avantageusement, la couche en MgO, HfO₂, Al₂O₃, SiO₂ ou Si₃N₄ peut diffuser jusqu'à la première couche 26 et faciliter la formation d'une zone de piégeage de charge.

Chaque cellule mémoire comprend en outre une électrode de grille 21.1, 22.1, 23.1. Dans le cas illustré à la Fig. 2, l'élément de support 24 est un nanofil à section cylindrique et le multicouche 25 est déposée autour de la paroi cylindrique du nanofil. Les électrodes de grille sont alors radialement extérieures au multicouche

Selon un autre mode de réalisation, non représenté à la figure 2, le nanofil peut avoir une paroi extérieure de forme non cylindrique. Dans ce cas le multicouche est déposé au contact de la paroi extérieure du nanofil. L'électrode de grille est alors déposée au contact du multicouche de sorte à être extérieure au nanofil.

Le canal conducteur électrique connecte en série les différentes cellules mémoire 21, 22, 23 formant la ligne mémoire 20.

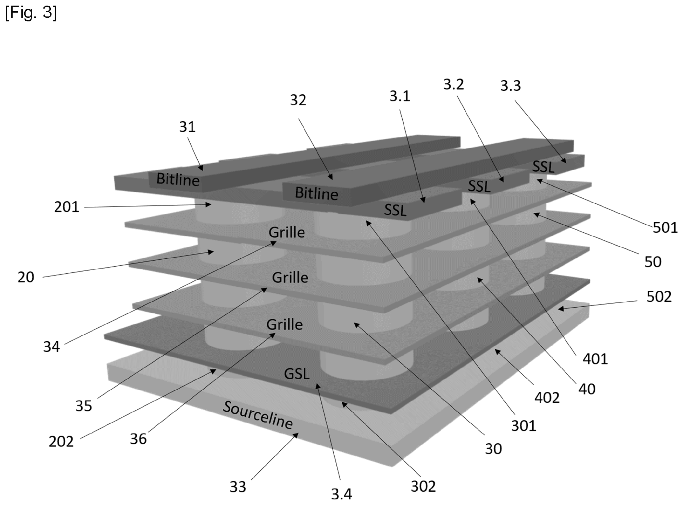

La [Fig. 3] illustre un mode de réalisation d'une mémoire 3D NAND Flash selon l'invention. Telle qu'illustrée à la Fig. 3, la mémoire 3D NAND Flash comprend une pluralité de lignes mémoire 20, 30, 40, 50. Chaque ligne mémoire s'étend entre un premier contact électrique dit drain de ligne mémoire 201, 301, 401, 501 et un deuxième contact électrique dit source de ligne mémoire 202, 302, 402, 502. Les lignes mémoires 20, 30, 40, 50 sont disposées parallèlement les unes aux autres.

La mémoire représentée à la Fig.3 comprend en outre un circuit de pilotage de mémoire adapté pour lire, programmer ou encore réinitialiser la mémoire 3D NAND Flash.

Le circuit de pilotage de la mémoire 3D NAND Flash comprend deux lignes de bit 31 et 32 ou bitline selon la terminologie anglaise et trois électrodes de sélection de ligne mémoire 3.1, 3.2 et 3.3 ou String Selector Line selon la terminologie anglaise.

Selon le mode de réalisation illustré à la Fig. 3, la mémoire 3D NAND Flash comprend des électrodes de grille 34, 35 et 36. Les électrodes de grille sont radialement extérieures aux cellules mémoire et s'étendent dans un plan normal à la direction des lignes mémoire 20, 30, 40, 50.

La configuration de mémoire 3D NAND Flash illustrée à la Fig. 3 est une architecture à canal vertical avec les électrodes de grille formant des plans horizontaux.

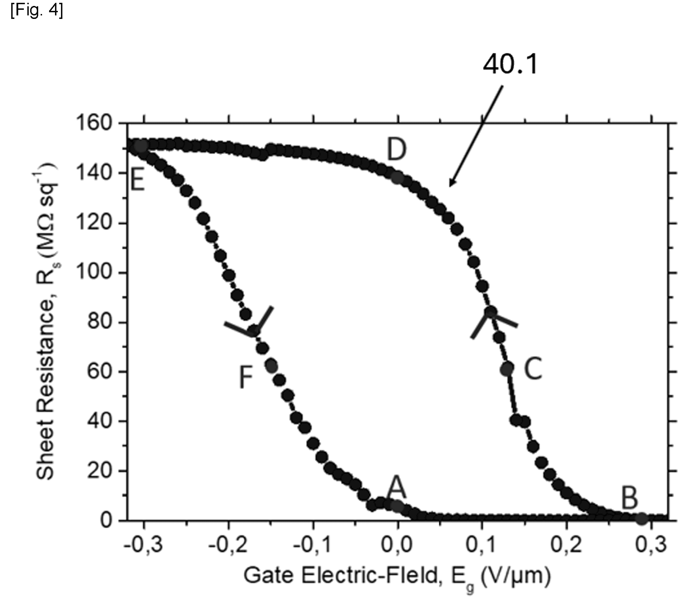

Selon un mode de réalisation de la mémoire 3D NAND Flash à canal vertical illustrée à la Fig. 3, l'empilement des couches de la cellule mémoire est une multicouche oxyde pérovskite/métal réducteur, à l'interface de laquelle un gaz bidimensionnel d'électrons se forme et assure le rôle de canal de conduction. De plus, lors de la formation de ce gaz d'électrons, une zone de piégeage de charges est également formée à la surface de l'oxyde, proche de l'interface. La multicouche peut par exemple être formée par SrTiO₃/Ta. Lors du dépôt, par exemple par dépôt par couche atomique (ou « atomic layer deposition », ALD, selon la terminologie anglaise) sur le SrTiO₃, le Ta va pomper les atomes d'oxygène du SrTiO₃ et s'oxyder en Ta₂O₅. Le SrTiO₃ est donc réduit et des lacunes d'oxygène se forment à la surface du SrTiO₃. Cette surface forme la zone de piégeage de charges, de sorte que la création à la fois du canal de conduction et de la couche de piégeage de charges est réalisée avec la multicouche SrTiO₃/Ta. Cet agencement permet de moduler la résistance du dispositif avec l'électrode de grille, tel qu'illustré à la Fig.4.

Selon un autre mode de réalisation non représenté à la figure 3, la mémoire NAND Flash tridimensionnelle selon un aspect de l'invention peut avoir une architecture à électrode de grille verticale. Dans ce cas, le canal est disposé horizontalement. Les électrodes de grille sont alors perpendiculaires aux canaux de la mémoire NAND Flash tridimensionnelle.

Il y a différente façons de fabriquer la mémoire 3D NAND Flash, en ce qui concerne la partie des lignes mémoires. Dans le premier cas, une alternance de couches grille/oxide est déposée sur un substrat/wafer et des cavités cylindriques (ou non) sont gravées de façon à former un quadrillage. Dans ces cavités, selon un mode de réalisation, on vient déposer sur les parois, par ALD, la multicouche puis en son centre l'élément de remplissage. C'est la fabrication dite « gate first ». Dans un deuxième cas, une alternance nitrure/oxide est déposée sur un substrat/wafer et des cavités cylindriques sont gravées de façon à former un quadrillage. Dans ces cavités, selon un mode de réalisation, on vient déposer sur les parois, par ALD, la multicouche puis en son centre l'élément de remplissage. Par gravure chimique, les couches de nitrures deviennent les couches de grille. C'est la fabrication dite « gate last ». Enfin, le dernier cas consiste à déposer en premier la ligne mémoire, c'est-à-dire, selon un mode de réalisation, d'abord l'élément de remplissage, puis le dépôt de la multicouche sur la paroi extérieure de l'élément de remplissage. Ensuite, l'alternance grille/oxide est déposée autour des lignes mémoires. Dans l'industrie, ce sont les deux premiers modes de fabrications qui sont favorisés.

Le graphe illustré à la Fig.4 représente la résistance surfacique 40.1 du gaz bidimensionnel d'électrons formé à l'interface oxyde/métal en fonction de la tension appliquée sur l'électrode de grille.

La courbe 401 montre une courbe d'hystérésis associée à la modulation non-volatile à base de piégeage de charges de l'état de conduction du gaz bidimensionnel d'électrons.

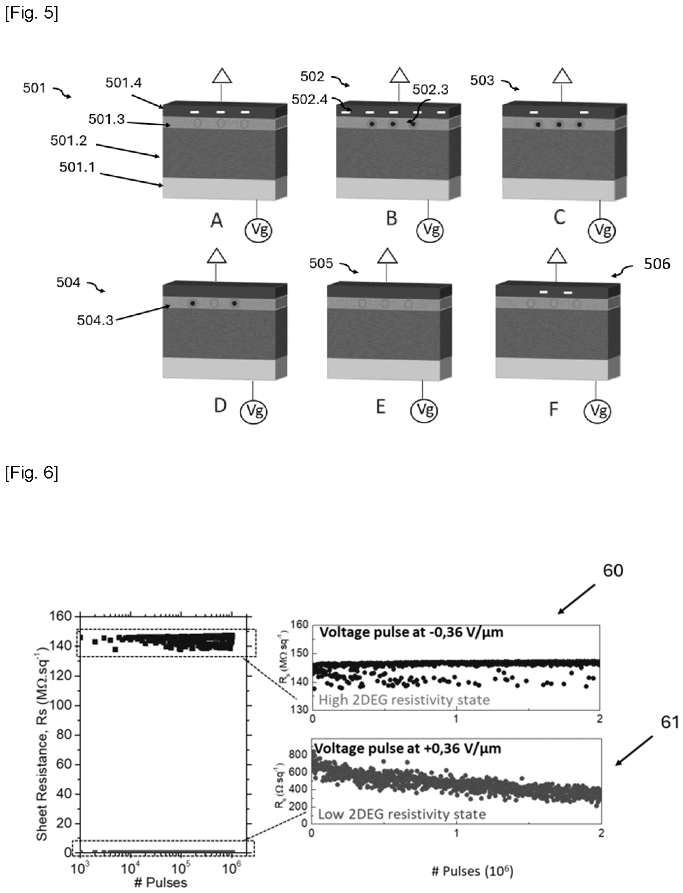

Les états A, B, C, D, E, F notés sur la courbe 40.1 sont illustrés schématiquement à la Fig. 5, qui montre des vues en coupe d'une multicouche oxyde pérovskite/métal.

La vue en coupe 501 correspond à l'état noté A sur la Fig. 4. La vue en coupe 501 illustre une électrode de grille 501.1 au contact d'une couche 501.2 en oxyde pérovskite, par exemple SrTiO₃. Un gaz bidimensionnel d'électrons 501.4 est formé à l'interface oxyde pérovskite/métal. Une zone de piégeage de charge est alors formée à la surface de la couche d'oxyde. Cette zone de piégeage de charges est riche en lacunes d'oxygène.

La vue en coupe 502 correspond à l'état B de la Fig.4, lorsqu'un potentiel positif est appliqué à l'électrode de grille 502.1. Dans ce cas, en appliquant un large champ électrique positif, le gaz est enrichi en électrons, et certains sont même piégés dans la zone de piégeage 502.3 de l'oxyde pérovskite. Le gaz bidimensionnel d'électrons 502.4 est alors dans un état très riche en électrons, et donc très conducteur avec une résistivité surfacique de l'ordre de 500 Ω/sq. Le canal a une conduction similaire à celle d'un métal : c'est le régime conducteur du transistor ou cellule mémoire. Lorsqu'on diminue le champ électrique, le gaz est peu à peu déplété tel qu'illustré dans la vue en coupe 503 correspondant à l'état C de la Fig.4.

Au-delà d'un champ seuil, les électrons piégés dans la zone de piégeage d'oxyde pérovskite sont dépiégés et des lacunes d'oxygène apparaissent dans la zone de piégeage de charges 504.3, comme illustré par la vue en coupe 504, et induisent une forte réduction de la mobilité des électrons dans le gaz. Cette situation correspond à l'état noté D à la Fig. 4.

La situation illustrée par la vue en coupe 505 correspond à l'état de saturation, noté E sur la Fig. 4. Dans l'état de saturation, le canal est alors dans un état très déplété et donc très résistif. Cela correspond au régime de coupure du transistor. En modulant le champ électrique par des valeurs négatives à positives, des électrons sont de nouveau injectés dans le gaz bidimensionnel d'électrons, ce qui rend le canal peu à peu conducteur avec des états intermédiaires comme sur la vue en coupe 506 qui correspond à l'état noté F, jusqu'à retrouver l'état initial et conducteur à un champ électrique nul correspondant à l'état noté A sur la Fig. 4.

L'empilement oxyde pérovskite présente de nombreux avantages pour la 3D NAND Flash, notamment par sa simplicité, avec seulement le dépôt d'une couche fine d'oxyde pérovskite et celle d'un métal réducteur. De plus, le gaz bidimensionnel d'électrons permet d'avoir de très bonnes performances en termes de conduction, de non-volatilité mais aussi d'endurance et de stabilité.

On peut en effet contrôler électriquement et de manière non-volatile la conductivité du gaz, et avoir ainsi deux états rémanents, l'un métallique (500 Ω/sq) et l'autre isolant (140 MΩ/sq), avec un ratio On/Off de 10⁴ en tant que transistor

La Fig. 6 illustre la résistivité de couche de l'état hautement résistif 60 et de l'état faiblement résistif 61 d'une cellule mémoire à gaz bidimensionnel d'électrons en fonction du nombre de cycles de la cellule mémoire. Le gaz bidimensionnel d'électrons permet d'avoir de très bonnes performances en termes de conduction, de non-volatilité mais aussi d'endurance et de stabilité. En effet, on peut contrôler électriquement et de manière non-volatile la conductivité du gaz, et avoir ainsi deux états rémanents. L'un métallique, possédant une résistivité de couche de l'ordre de 500 Ω/sq et l'autre isolant, possédant une résistivité de couche de l'ordre de 140 MΩ/sq. avec un ratio On/Off de 10⁴. Par ailleurs, l'endurance est supérieure à 10⁶ cycles et la stabilité peut être extrapolée jusqu'à 10 ans.

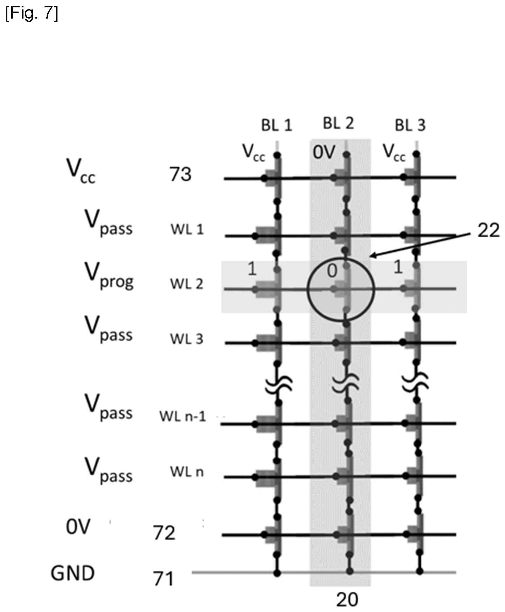

La Fig. 7 illustre une opération de programmation d'une cellule mémoire d'une ligne mémoire 20 d'une mémoire NAND Flash tridimensionnelle. Telle qu'illustrée à la Fig. 7 la mémoire NAND Flash tridimensionnelle comprend trois lignes mémoire, chacune connectée à une des lignes de bit BL1, BL2 ou BL3. Les trois lignes mémoire sont également connectées à une électrode de source de ligne 71. De plus, chaque ligne mémoire est connectée à une électrode de sélection de ligne 73 ou String Select Line selon la terminologie anglaise et à une électrode de sélection de source 72 ou Ground Select Line selon la terminologie anglaise.

Toutes les cellules mémoire représentées à la Fig. 7 sont initialement à l'état passant ou faiblement résistif ou encore à l'état 1. Les électrodes de grille sont indiquées par WL1, WL2 jusqu'à WLn sur la Fig. 7.

Afin de programmer la cellule mémoire 22 de la ligne mémoire 20, on applique une tension V_{prog} sur l'électrode de grille WL2 et Vₚₐₛₛ sur les autres électrodes de grille. Concernant les lignes de bit, on applique 0 V sur la BL 2 et Vcc ≥ V_{prog} sur les autres. De cette façon, seule la cellule mémoire 22 sera programmée car la tension appliquée entre la grille et le drain sera supérieure à la tension de seuil, contrairement aux autres cellules mémoire qui seront maintenues dans leur état passant.

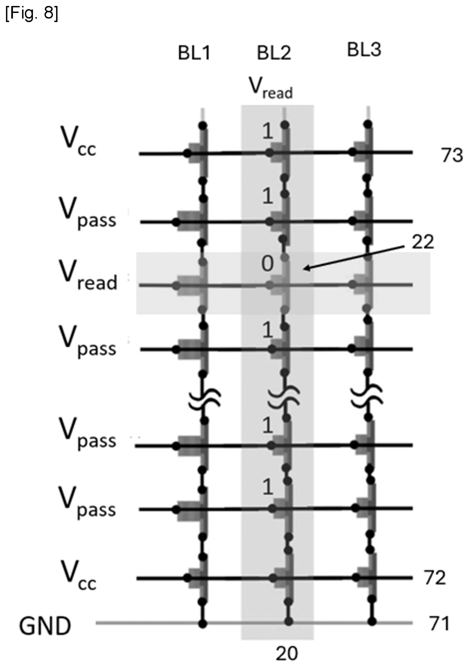

La Fig. 8 illustre une opération de lecture d'une cellule mémoire d'une ligne mémoire 20 d'une mémoire NAND Flash tridimensionnelle. Telle qu'illustrée à la Fig. 8 la mémoire NAND Flash tridimensionnelle comprend trois lignes mémoire, chacune connectée à une des lignes de bit BL1, BL2 ou BL3. Les trois lignes mémoire sont également connectées à une électrode de source de ligne 71. De plus, chaque ligne mémoire est connectée à une électrode de sélection de ligne 73 ou String Select Line selon la terminologie anglaise et à une électrode de sélection de source 72 ou Ground Select Line selon la terminologie anglaise.

Concernant la lecture, on applique une très faible tension V_{read} sur la ligne mémoire 20 que l'on cherche à lire et une forte tension Vₚₐₛₛ sur toutes les autres électrodes de grille WL1 à WLn, afin que, quel que soit l'état des cellules mémoires, le courant puisse passer. On applique également un tension Vread sur la ligne de bit BL2. Ainsi, si le courant passe le long de la ligne mémoire 20, alors la cellule mémoire sélectionnée par la ligne de bit et la ligne de mot (ici la cellule 22) est dans l'état passant 1. En revanche, si aucun courant (ou un très faible courant) est détecté dans la ligne mémoire 20, alors la cellule mémoire sélectionnée 22 de la ligne est dans l'état 0.

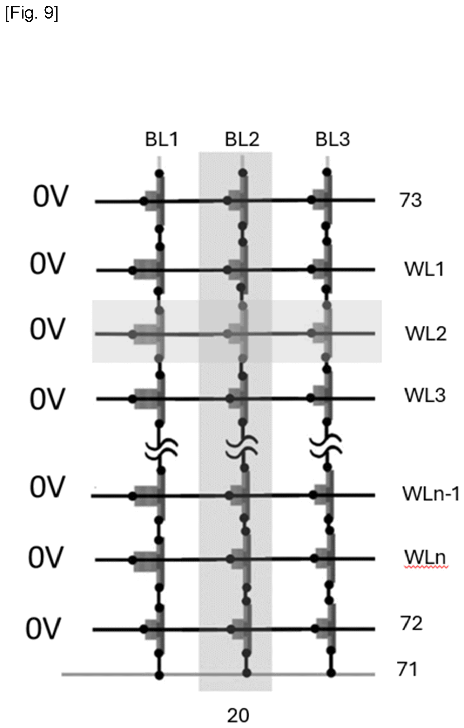

La Fig. 9 illustre une opération de réinitialisation d'un bloc de cellules mémoire d'une mémoire NAND Flash tridimensionnelle. Telle qu'illustrée à la Fig. 9, la mémoire NAND Flash tridimensionnelle comprend trois lignes mémoire, chacune connectée à une des lignes de bit BL1, BL2 ou BL3. Les trois lignes mémoire sont également connectées à une électrode de source de ligne. 71. De plus, chaque ligne mémoire est connectée à une électrode de sélection de ligne 73 ou String Select Line selon la terminologie anglaise et à une électrode de sélection de source 72 ou Ground Select Line selon la terminologie anglaise.

La réinitialisation permet d'avoir tous les éléments de mémoire d'un bloc dans l'état passant, qui correspond à leur état initial. On applique une tension de 0 V sur toutes les électrodes de grille WL1, WL2...WLn et une tension V_{prog} sur la ligne de source, ce qui revient à appliquer -V_{prog} sur chacune des lignes de bit.

## Revendications

1. Mémoire de type Flash NAND comprenant une pluralité de lignes mémoire (20, 30, 40, 50), lesdites lignes mémoire (20, 30, 40, 50) étant disposées pour former une architecture tridimensionnelle de mémoire Flash NAND, chaque ligne mémoire (20) comprenant :
- un ensemble (21, 22, 23) de cellules mémoire connectées en série ;
- une multicouche (25) comprenant une première couche (26) et une deuxième couche (27), la première couche (26) comprenant un oxyde, la deuxième couche (27) comprenant un métal réducteur, la deuxième couche (27) étant au contact de la première couche (26) de sorte à former une interface entre la première (26) et la deuxième couche (27), la multicouche (25) comprenant en outre un gaz bidimensionnel d'électrons à l'interface entre la première (26) et la deuxième couche (27), ledit gaz bidimensionnel d'électrons formant un canal conducteur électrique (25.1) connectant en série les cellules mémoire comprises dans ledit ensemble (21, 22, 23) ;
- un élément de remplissage (24) dudit ensemble (21, 22, 23) de cellules mémoires connectées en série, ledit élément de remplissage (24) étant en matériau isolant, ladite multicouche (25) étant au contact de l'élément de remplissage (24) ;
- chaque cellule mémoire (21, 22, 23) comprenant :
- un sous-ensemble à états rémanents présentant deux états rémanents contrôlables électriquement, ledit sous-ensemble à états rémanents étant en contact avec le canal conducteur électrique (25.1), chaque état rémanent contrôlable électriquement étant associé à une valeur différente de conductivité du canal conducteur électrique (25.1) ;
- une électrode de grille (21.1, 22.1, 23.1) en contact avec le multicouche pour contrôler électriquement les deux états rémanents.

2. Mémoire selon la revendication précédente dans laquelle la première couche (26) comprend le sous-ensemble à états rémanents.

3. Mémoire selon la revendication précédente dans laquelle la première couche (26) comprend l'élément de remplissage (24).

4. Mémoire selon l'une des revendications précédentes dans laquelle chaque ligne mémoire (20, 30, 40, 50) s'étend entre un premier contact électrique dit drain de ligne mémoire (201, 301, 401, 501) et un deuxième contact électrique dit source de ligne mémoire (202, 302, 402, 502), ladite mémoire comprenant en outre un circuit de pilotage de mémoire, ledit circuit de pilotage comprenant :
- Au moins une ligne de bit (31, 32) connectant plusieurs drains de ligne mémoire ;
- Au moins un sélecteur de ligne mémoire (SSL, 3.1, 3.2, 3.3) composé de transistors volatils ;
- Au moins une ligne de sélecteur de source (3.4) composée de transistors volatils;
- Au moins une ligne de source (33) connectant plusieurs sources de ligne mémoire ;
- Au moins une ligne de mot (34, 35, 36) connectant les électrodes de grille de cellules mémoires appartenant à des lignes mémoire différentes (20, 30, 40, 50).

5. Mémoire selon la revendication précédente dans laquelle les lignes mémoire (20, 30, 40, 50) sont parallèles les unes aux autres.

6. Mémoire selon l'une des revendications précédentes dans laquelle la première couche (26) comprend un oxyde pérovskite choisi dans un groupe comprenant des composés chimiques de type ABO₃, A et B étant des cations, ledit groupe comprenant : SrTiO₃, KaTiO₃, BaTiO₃ , PbZr₁₋ₓTiₓO₃ avec x variant entre 0 et 1, [1-x]Pb(Mg_{1/3}Nb_{2/3})O₃ - xPbTiO₃ avec x variant entre 0 et 1, BiFeO₃, Pr_{0,7}Ca_{0,3}MnO₃ et YMnO₃.

7. Mémoire selon l'une des revendications 1 à 5 dans laquelle la première couche (26) comprend un oxyde d'Hafnium de type Hf₁₋ₓMₓ0₂, avec M étant par exemple Zr, Ga, Y et x variant entre 0 et 1, ou un alliage de (Hf₁₋ₓZrₓ)0₂ et (Hf₁₋ₓGaₓ)0₂.

8. Mémoire selon l'une des revendications 1 à 5 dans laquelle la première couche (26) comprend du poly-fluorure de vinylidène.

9. Mémoire selon l'une des revendications 1 à 5 dans laquelle la première couche (26) comprend un matériau de type pérovskite aux halogénures métalliques choisi dans un groupe comprenant : CsPbBr₃, MAPbl₃, ou MAPbBr₃

10. Mémoire selon l'une des revendications 1 à 5 dans laquelle la première couche (26) comprend un oxyde choisi dans le groupe suivant : SiOₓNₓ, (Ta₂O₅)ₓ (TiO₂)₁₋ₓ ou (Nb₂O₅₎ₓ(TiNb₂O₇)₁₋ₓ avec x variant entre 0 et 1.

11. Mémoire selon l'une des revendications 1 à 5 dans laquelle l'oxyde est choisi dans le groupe comprenant : oxyde de vanadium (VO2), oxyde de gadolinium (Gd2O3), oxyde de zinc (ZnO) ou oxyde de chrome (CrO2), ou un mélange ou combinaison d'éléments de ce groupe.

12. Mémoire selon l'une des revendications 1 à 5 dans laquelle l'oxyde est un oxyde conducteur choisi dans le groupe comprenant : oxyde d'étain et d'indium (ITO), oxyde d'étain dopé au fluor (FTO), anatase TiO2 dopé au niobium (NTO), oxyde de zinc ou une combinaison ou mélange d'éléments de ce groupe.

13. Mémoire selon l'une des revendications précédentes dans laquelle la deuxième couche (27) comprend un métal réducteur, ledit métal réducteur étant de préférence choisi dans le groupe comprenant : tantale, yttrium, magnésium, aluminium et ruthénium.

14. Mémoire selon l'une des revendications précédentes dans laquelle la deuxième couche (27) présente une concentration atomique en métal supérieure ou égale à 50%.

15. Mémoire selon l'une des revendications précédentes dans laquelle le sous-ensemble à états rémanents comprend une couche contrôlable électriquement par effet de charge piégée ou par effet ferroélectrique ou par effet de migration d'ions ou par combinaison de plusieurs de ces effets.

16. Mémoire selon l'une des revendications précédentes dans laquelle chaque cellule mémoire (21, 22, 23) comprend :
- une première zone dite zone de source ;
- une deuxième zone dite zone de drain ;
- la zone de source et la zone de drain étant électriquement connectées par une portion du canal conducteur électrique (25.1) s'étendant entre la zone de source et la zone de drain.

17. Mémoire selon l'une des revendications précédentes dans laquelle la première couche (26) est déposée au contact de la grille, la deuxième couche (27) est déposée au contact de la première couche (26) et l'élément de remplissage (24) est déposé au cœur du canal conducteur électrique (25.1) , au contact de la deuxième couche (27).

18. Mémoire selon l'une des revendications 1 à 16 dans laquelle l'élément de remplissage (24) est déposé au contact de la grille, la deuxième couche (27) est déposée au contact de l'élément de remplissage (24) et la première couche (26) est déposée au contact de la deuxième couche (27).

19. Mémoire selon l'une des revendications précédentes dans laquelle le matériau isolant formant l'élément de remplissage (24) est fait du même oxyde que celui compris dans la première couche (26).

20. Mémoire selon l'une des revendications précédentes dans laquelle le multicouche comprend en outre une couche en MgO ou en HfO₂ ou en Al₂O₃ ou en SiO₂ ou en Si₃N₄, ladite couche étant déposée au contact de la deuxième couche (27).

21. Procédé de fabrication d'une mémoire Flash NAND selon l'une des revendications précédentes, ledit procédé comprenant une étape de dépôt de la première couche et une étape de dépôt de la deuxième couche, le dépôt étant un dépôt par couches atomiques.
